(19) Europäisches Patentamt
European Patent Office
Office européen des brevets

(11) EP 0 788 169 A2

(12) **EUROPEAN PATENT APPLICATION**

(43) Date of publication:
**06.08.1997 Bulletin 1997/32**

(51) Int. Cl.[6]: **H01L 29/74**, H01L 21/332

(21) Application number: **97101472.5**

(22) Date of filing: **30.01.1997**

(84) Designated Contracting States:
**CH DE FR GB LI NL SE**

(30) Priority: **30.01.1996 JP 13595/96**

(71) Applicant: **HITACHI, LTD.**
**Chiyoda-ku, Tokyo 101 (JP)**

(72) Inventors:
- **Morishima, Makoto**
  **Hitachi-shi, Ibaraki 316 (JP)**
- **Suzuki, Kazuhiro**
  **Mito-shi, Ibaraki 310 (JP)**
- **Murakami, Susumu**
  **Hitachinaka-shi, Ibaraki 312 (JP)**
- **Onose, Yasuo**
  **Naka-gun, Ibaraki 319-11 (JP)**

(74) Representative: **Beetz & Partner**
**Patentanwälte**
**Steinsdorfstrasse 10**
**80538 München (DE)**

(54) **High voltage semiconductor device having stable voltage blocking characteristics**

(57) A semiconductor device having a semiconductor substrate having a main surface and an opposite surface and at least one p-n junction exposed partially to a side surface of the substrate and a multi-layered structure of passivation films having two or more passivation films (5, 8, 11, 17) coated on the side surface of said semiconductor substrate, wherein an interface polarization charge Qr (coulomb/cm$^2$) induced in the vicinity of an interface between a first passivation film provided on the surface of said semiconductor substrate and a second passivation film provided on the surface of said first passivation film is in a relationship expressed by equation 1,

$$1.6 \times 10^{-8} \geq |Qr| \qquad (1),$$

and wherein a conductivity $\sigma_1$ of said first passivation film and a conductivity $\sigma_2$ of said second passivation film satisfy

$$0.05 \leq \sigma_2/\sigma_1 \leq 10 \qquad (2),$$

thereby, interface polarization which induces charge density is avoided to restrict variation or increasing of leakage current of the semiconductor device.

*FIG.1*

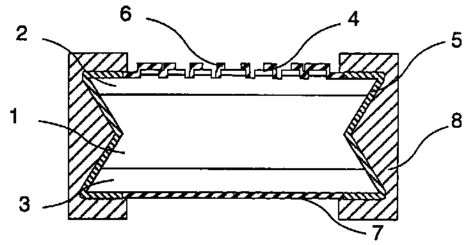


EP 0 788 169 A2

## Description

BACKGROUND OF THE INVENTION

Field of the Invention

The present invention relates generally to a semiconductor device, such as thyristor, diode and so forth, to which a high voltage is applied. More specifically, the invention relates to a high-voltage semiconductor device having stable voltage blocking characteristics even upon application of high voltage.

Description of the Related Art

One example of high-voltage semiconductor device has been disclosed in IEEE Prog. Vol. 129 Pt. I No. 5 173 (1982).

For providing high reliability for the high-voltage semiconductor, various technologies have been proposed conventionally. In the conventional high-voltage semiconductor device, such as thyristor, gate turn-off thyristor, diode and so forth, side surface of a semiconductor substrate is processed to have bevelled contour, and a passivation film is formed on the side surface. For example, Japanese Unexamined Patent Publication (Kokai) No. Heisei 6-53485 discloses a prior proposed technology for providing higher reliability for the semiconductor device. In the disclosed conventional technology, the side surface of the thyristor beveled to have a concave at the center portion in the thickness direction.

By providing a double positive bevelled contour, when a reverse bias voltage is applied to one p-n junction of p-n-p structure portion of the side surface of the semiconductor substrate, depletion layer of the surface of the p-n junction is mainly extended toward the n layer by positive bevel structure to provide higher break down voltage for the semiconductor device. Conversely, the concave portion of side surface makes it difficult to spread the depletion layer. This is advantageous for capability of prevention of punch-through. The side surface of the semiconductor device exposing the p-n junction and the surface exposing the semiconductor substratum are protected by an insulation layer, such as a polyimide layer, and an insulation layer, such as silicon rubber layer, formed on the former insulation layer for achieving higher reliability.

However, in the prior art set forth above, there is no disclosure for a solution for a problem of adverse effect on blocking characteristics of a charge generated in the passivation film due to difference of conductivity between the insulation layers in high temperature blocking test.

When an electric field strength charged to the passivation film according to demand for higher breakdown voltage of the semiconductor device, reliability of the passivation film should significantly affect for reliability of the semiconductor device.

One of important factors which the passivation film effects for blocking characteristics of the semiconductor device is net charge density of the semiconductor. When the net charge density is varied, drawbacks, such as increasing of leakage current, lowering of breakdown voltage or so forth, may cause in the semiconductor element, In general, the net charge density is variable depending upon a charge in the vicinity of an interface between the semiconductor and the passivation film.

In a passivation process for forming the passivation film, at first, a peripheral portion of the semiconductor substrate is ground to form a double positive bevel contour. In order to clean chipping and contamination on the ground surface, chemical etching is performed for the processed surface. On the etched surface, a resin, such as polyimide or so forth, is applied, dried and cured. Conventionally, drying and curing of the applied resin is performed in an oven. While drying in the oven, the resin is gradually cured from the surface. At this time, the resin deposited in the concave of the double positive bevel gradually flows downward to cause a change locally in a resin amount in that the resin layer becomes thin at the upper side surface and thick at the lower side surface, and is cured with the deviation of thickness (see Fig. 11). Evaluating breakdown voltage of the second passivation film formed on the first passivation film causing local deviation in thickness, it can be appreciated that the breakdown voltage is lower at the side having thinner layer thickness of the first passivation film. Furthermore, when the high temperature blocking test is performed for such semiconductor element, it has been appreciated that current-voltage characteristics is graded at the side where the first passivation film is thinner.

SUMMARY OF THE INVENTION

It is therefore an object of the present invention to provide a semiconductor device, which can increase leakage current during operation of the semiconductor device, and may maintain stable characteristics for a long period to achieve high reliability.

The net charge density is affected by interface polarization 9, 10 in Fig. 2 caused in the vicinity of an interface of a polyimide and a silicon rubber due to difference of conductivity of a passivation films. Namely, by a charge generated by the interface polarization, a charge is induced on the surface of the semiconductor. By the induced charge, the net charge density is varied to cause degradation of the blocking characteristics and affect for long period reliability of the semiconductor device.

A semiconductor device, according to the present invention, having a semiconductor substrate having a main surface and an opposite surface, at least one p-n junction partially exposed to a side surface of the semiconductor substrate and a multi-layered passivation structure having two or more passivation films coated on the side surface of the semiconductor substrate, wherein an interface polarization charge Qr (coulomb/$cm^2$) induced in the vicinity of an interface between a first passivation film provided on the side surface of said semiconductor substrate and a second passivation film provided on the surface of said first passivation film satisfies

$$1.602 \times 10^{-8} \geqq |Qr| \qquad (1).$$

The above-mentioned interface polarization charge Qr induces a charge on the silicon surface corresponding to each charge depending on each capacitance of each passivation film wherein a relationship between an induced charge Qs' induced on the silicon surface by the interface polarization charge and Qr is expressed by the following equation (3),

$$Qs' = (C_1/C_1+C_2) \times Qr \qquad (3),$$

where $C_1$ and $C_2$ is an electrostatic capacitance of the first and the second passivation films, respectively. The electrostatic capacitance is obtained by dividing a dielectric constant by a film thickness. For example, dielectric constant of polyimide is from 2.5 to 3.5 at 1 kHz at room temperatures, and that of silicone rubber is from 2.5 to 3.0 at 1 kHz at room temperatures. On the other hand, in comparison of film thickness of the first and the second passivation films, since the first passivation film is thicker than the second passivation film, i.e., $C_2 \leqq C_1$, consequently, there holds

$$1/2 \leqq (C_1/C_1+C_2) < 1.$$

Here, an appropriate value of a net charge density obtained by simulation is preferably in a range of $+1 \times 10^{11}$[$cm^{-2}$] and $+3 \times 10^{11}$[$cm^{-2}$], an absolute value of an appropriate value of Qs' is $|Qr| < 1.6 \times 10^{-8}$[coulomb/$cm^2$].

A semiconductor device, according to the present invention, having a semiconductor substrate having a main surface and an opposite surface, at least one p-n junction partially exposed to a side surface of the semiconductor substrate and a multi-layered passivation structure having two or more passivation films coated on the side surface of the semiconductor substrate, wherein a conductivity $\sigma_1$ of a passivation film (first passivation film) provided on the side surface of the semiconductor substrate and a conductivity $\sigma_2$ of a passivation film (second passivation film) provided on the surface of the first passivation film satisfy

$$0.05 \leq \sigma_2/\sigma_1 \leq 10 \qquad (2)$$

The net charge density is varied depending upon a charge existing in the passivation film, and is particularly affected by interface polarization caused on the interface between the first and second passivation films. The interface polarization is caused at the interface of materials having different dielectric constants and conductivity. Especially, contribution of the conductivity is significant. The interface polarization affecting for the net charge density may be caused when a difference of conductivity of the first passivation film and the conductivity of the second passivation film become large. A relationship of the arithmetically derived charge density and the $\sigma_2/\sigma_1$ is shown in Fig. 3. A change of the net charge density should be restricted to be ±50% by setting the ratio $\sigma_2/\sigma_1$ of the conductivity $\sigma_1$ of the first passivation film and the conductivity $\sigma_2$ of the second passivation film in a range of 0.05 to 10.

Also, the semiconductor device, according to the present invention, considering that the thickness of the n-type base layer is a width to which the depletion layer is spread, by setting the thickness of the n-type base layer to be greater than or equal to 100 μm and less than or equal to 5000 μm, breakdown voltage from 1 kV of the semiconductor substrate having impurity concentration $1.0 \times 10^{14}$ of the n-type base layer to 30 kV of the semiconductor substrate having impurity concentration $2.0 \times 10^{12}$ of the n-type base layer can be achieved.

Furthermore, the semiconductor device according to the present invention may achieve breakdown voltage adapted for the maximum rated voltage in a range of 6 kV to 12 kV by setting the thickness of the n-type base layer in a range greater than or equal to 1000 μm and less than or equal to 2000 μm when a specific resistance of the n-type layer is 500 ± 50 Ωcm.

Also, the semiconductor device of the present invention, can have stable physical property in a range from -40 °C to 125 °C of operation temperature of the device by employing an organic material having glass transition temperature of the first passivation film in a range higher than or equal to 150 °C and lower than or equal to 400 °C. As the organic material, polyimide, polyamide, polybenzoxyzol, polybenzimidazol, polybenzo-para-diazine, polyether, polyether ether ketone, polyarylate and mixture thereof. The reason why the glass transition temperature is set to be lower than or equal to 400 °C is a life time of the carrier in the semiconductor element. The high voltage semiconductor to be employed in the inverter or converter controls the life time of the carrier flowing through the semiconductor for minimizing loss during power conversion. In the life time control, by annealing of crystal defect formed in irradiating radiation on the semiconductor substrate, an appropriate life time is obtained. When the semiconductor substrate is heated at a temperature higher than or equal to 400 °C for forming the passivation layer, the life time which is controlled at an appropriate value should varied to make it difficult to obtain satisfactory performance of the apparatus. Here, an organic material having the glass transition temperature higher than or equal to 400 °C, such as a part of polyimides cannot be used for the semiconductor device since it requires heat treatment at a temperature higher than or equal to 400 °C for terminating imidizing reaction upon formation of the passivation film.

Furthermore, in the semiconductor device, according to the present invention, an elastomer of the second passivation film provided on the surface of the first passivation layer is formed of additive reaction type silicon rubber. The silicon rubber is a insulation material having superior electrical property in wide temperature range. The silicon rubber can be classified into additive reaction type and condensation reaction type depending upon curing reaction mechanism. The condensation reaction type silicon rubber is the type which progresses curing reaction at room temperature with taking moisture as co-catalyst to generate reaction by-product of low molecular weight associated with reaction. On the other hand, the additive reaction type silicon rubber is a type progressing curing reaction by heat and generates no reaction by-product. Many of power semiconductor devices are sealed in ceramic packages in gas-tight fashion. When the condensation reaction type silicon rubber is left in high temperature in the sealed condition, rubber is decomposed by reverse curing reaction. Therefore, the condensation reaction type silicon rubber is the material having low heat resistance in the sealed condition. Fig. 13 shows a result of high temperature storage test of the semiconductor devices fabricated with employing the condensation reaction type silicon rubber. From Fig. 13, it should be appreciated that the semiconductor devices fabricated with the condensation reaction type silicon rubber cause degradation of blocking characteristics for the reason set forth above.

Furthermore, in the semiconductor device according to the present invention, when inorganic material, such as $SiO_2$, SiN, SiC and so forth, is used as material for the first passivation film, the passivation layer may contain lesser impurity. However, since inorganic material has higher elasticity and thus may possibly cause crack in the passivation film due to stress caused by difference of thermal expansion with the semiconductor forming thick layer. Therefore, when the inorganic material is used as the first passivation layer, the second passivation film and further a third passivation layer become necessary. At this time, it is desirable to use organic material having glass transition temperature higher than or equal to 150 °C to the 400 °C or silicon rubber as the second or a third passivation layer.

Also, the semiconductor device according to the present invention may form a diode, a gate turn-off thyristor (GTO) adapted for high breakdown voltage by appropriately shaping the side surface in the periphery of the semiconductor substrate into a positive bevel.

Furthermore, the semiconductor device according to the present invention, may form a thyristor adapted for high breakdown voltage and large current by providing Σ shaped with smooth Σ shaped end face. Furthermore, the semiconductor device according to the present invention has a semiconductor substrate having a main and an opposite surfaces and at least one p-n junction partially exposed to a side surface thereof and a multi-layered structure of passivation having two or more passivation films laminated on the side surface of said semiconductor substrate. A first passivation film provided on the surface of the side surface of the semiconductor substrate is formed in such a manner that the largest thickness of the first passivation film is attained at the position corresponding to the surface of the n-type base. The turning point in the double bevel structure is the position where the electric field concentrates. This point is also the n-type base layer. Namely, by forming the first passivation film as in the present invention, affect of the interface polarization can be decreased. In conjunction therewith, it becomes possible to obtain the superior semiconductor device which has equivalent current-voltage characteristics in both of the forward and reverse directions, and superior in long period reliability.

A fabrication method of the first passivation film having layer thickness distribution as shown in Fig. 7 is to perform spinning off of the excessive resin by rotating the semiconductor substrate after application of the resin. Then, the resin forming the first passivation film is moved to a hot plate heated at a given temperature for drying and curing. By this, heat is transmitted from the semiconductor substrate to the resin uniformly for drying and for preventing the resin from flowing freely, Furthermore, drying and curing period can be significantly shortened to be about 1/10 to 1/20 of the prior art. Also, when drying with the hot plate is sufficient, curing of the resin may be performed on the die.

Furthermore, the semiconductor device according to the present invention, has a semiconductor substrate having one and the other principle surfaces and at least one p-n junction exposed to an end face and two or more passivation layers laminated on the surface of the p-n junction exposed on the side surface of said semiconductor substrate, wherein, a high temperature blocking test as a duration resting method of said semiconductor device is performed by setting said semiconductor device to have p-n junction temperature of semiconductor element at 100 °C, continuously applying direct current of 70% of a maximum rated voltage for 1000 hours, and variation of leakage current before and after testing at 25°C at the maximum rated voltage of said semiconductor device is less than or equal to ±50%. Thus, the semiconductor achieving high reliability can be fabricated. As to a thickness of the first passivation layer in each semiconductor device according to the present invention, what is most important is a thickness thereof at a side surface of n-base layer having a low impurity concentration, and the value of which thickness is preferably more than 5 μm so that an occurrence of crack due to heat cycle can be prevented. A region where most electrical field concentrates in the side surface of the base layer having a low impurity concentration is at a point of inflection of the double positive bevel contour, i.e. in the center of Σ contour. Therefore, a film thickness of the first passivation film at this point of inflection is preferably more than 10 μm, and more preferably in a range of 30-100 μm. A thickness of the first passivation film in other regions (i.e. in the side surfaces of n-base layer or p-emitter layer) other than the vicinity of the low impurity concentration base layer, and in particular, in a place distant from the low impurity concentration base layer may be reduced to 1 μm or less. Furthermore, a power converter according to the present invention, may contribute for lowering of cost of a direct current power transmission system by employing the highly reliable high breakdown voltage and large current semiconductor device. In concrete, upon constructing of the direct current transmission system having transmission capacity of 1400 MW, 1440 semiconductor devices are required in the case of 6 kV, whereas 960 semiconductor device which is approximately 2/3 of the number of the device in the prior art. This permits substantial reduction of the associated facility and land required for the power converting station can be eliminated for about 32%.

In addition, the semiconductor device according to the present invention may improve loss capacity in the extent of several % than the conventional device by setting the loss in the segment to be lower than or equal to 4000 W and, more particularly to be lower than or equal to 3600 W. Here, the element loss is defined as (maximum ON voltage) x (average On current)/(phase number), loss capacity ratio is defined by (element loss)/maximum rated voltage. Concretely, comparing a light-activated thyristor having rated voltage of 8 kV and 3.5 kA, the element and the thyristor having rated voltage of 6 kV and 2.5 kA, the element, the element loss of the light-activated thyristor of 8 kV and 3.5 kA is (2.8V x 3500A)/(three phases) ≒ 3270W, whereas the element, the element loss of the light-activated thyristor of 6 kV, 2.5 kA is (2.3V x 2500A)/(three phases) ≒ 1920W. On the other hand, the loss capacity ratio of the thyristor of 8 kV, 3.5 kA is 3270/(8000V x 3500A) = 1.16e-4, the loss capacity ratio of the thyristor of 6 kV, 2.5 kA is 1920W/(6000V x 2500A) = 1.28e-4. As can be clear from this, by employing the optical thyristor of 8 kV, 3.5 kA rather than the optical thyristor of 6 kV, 2.5 kA, approximately 9.4% of element loss among overall loss can be eliminated.

## BRIEF DESCRIPTION OF THE DRAWINGS

The present invention will be understood more fully from the detailed description given herebelow and from the accompanying drawings of the preferred embodiment of the invention, which, however, should not be taken to be limitative to the present invention, but are for explanation and understanding only.

In the drawings:

Fig.1 is a section of the preferred embodiment of a semiconductor device according to the present invention;
Fig. 2 is an explanatory illustration showing an interface polarization;
Fig. 3 is a chart showing a relationship between a ratio $\sigma_2/\sigma_1$ of a conductivity $\sigma_1$, of a first passivation film and a conductivity $\sigma_2$ of a second passivation film, and a charge density;
Figs. 4A to 4D are explanatory illustration showing a fabrication process of the preferred embodiment of the semiconductor device according to the invention;
Fig. 5 is a chart showing a current-voltage characteristics of the preferred embodiment and comparative example of semiconductor device according to the invention;
Fig. 6 is a section showing the preferred embodiment of the semiconductor device according to the invention;
Fig. 7 is a section showing another embodiment of the semiconductor device according to the invention;
Fig. 8 is a section showing a further embodiment of the semiconductor device according to the invention;
Fig. 9 is an explanatory illustration of the embodiment of the present invention;
Fig. 10 is an explanatory illustration of the embodiment of the present invention;
Fig. 11 is a section of the conventional semiconductor device;
Fig. 12 is a chart showing a current-voltage characteristics of the embodiment and comparative example of the semiconductor device according to the invention;
Fig. 13 is a chart showing a current-voltage characteristics of the comparative example of the semiconductor device before and after high temperature storage test;
Fig. 14 is a section of the preferred embodiment of a gate turn-OFF thyristor according to the invention;
Fig. 15 is a section of the preferred embodiment of a diode according to the invention;
Fig. 16 is a circuit diagram showing an external rectifier circuit employing the semiconductor device according to the invention;
Fig. 17 is a circuit diagram showing an external inverter circuit employing the semiconductor device according to the invention;
Fig. 18 is a circuit diagram showing an external cyclo converter circuit employing the semiconductor device according to the invention;

Fig. 19 is a circuit diagram showing a snubber circuit of a gate turn-OFF thyristor employing the diode according to the invention;

Fig. 20 is a circuit diagram showing an inverter circuit employing the diode and gate turn-OFF thyristor according to the invention; and

Fig. 21 is an enlarged drawing in part of Fig. 20.

DESCRIPTION OF THE PREFERRED EMBODIMENT

The present invention will be discussed hereinafter in detail in terms of the preferred embodiment of the present invention with reference to the accompanying drawings. In the following description, numerous specific details are set forth in order to provide a thorough understanding of the present invention. It will be obvious, however to those skilled in the art that the present invention may be practiced without these specific details. In other instance, well-known structures are not shown in detail in order to avoid unnecessary obscure the present invention.

On a 4 inch silicon wafer with a preliminarily deposited Al layer in a thickness of 1 μm (manufactured by Shinetsu Kagaku Kogyo K. K.), a sample resin was applied by a spin coating method. Then, the resin was cured in a predetermined condition, and an Al upper electrode (ϕ30 to 50) was formed on the resin layer by vacuum deposition to form a measuring sample. Layer thickness of the resin was measured by cutting three portions of thin film from the measuring sample, using a profilometer (Dectak 3030, Sloan Technology Corporation). In order to eliminate influence of moisture content, the measuring sample way dried at 190 °C for 16 hours in a vacuum. Thereafter, in nitrogen gas flow, a current flowing through the resin was measured at 30 °C by means of ultra high resistance meter (R8340 Advantest). Based on the measured current value, a conductivity $\sigma$ was derived through the following equation (4)

$$\sigma = (I_r \times d)/(V \times S) \quad (4)$$

wherein V: charged voltage, S: an area of electrode, $I_r$: leakage current: and d: layer thickness

On the other hand, by means of a microtometer, a cut piece in a thickness of 1 μm is cut out from the semiconductor device. Then, Al electrode is deposited in a vacuum. Thereafter, the conductivity was measured. The results of the measurement are shown in the following table 1:

TABLE 1

| CONDUCTIVITY OF RESIN AFTER CURING | | | | | | | |
|---|---|---|---|---|---|---|---|
| | KJR652 | KJR9028 | KJR9060 | KJR9063 | KJR9025 | JCR6121 | TSJ3150 |
| Measuring Sample | 1.66e-17 | 5.32e-19 | 1.42e-18 | 3.18e-18 | 2.94e-17 | 8.70e-17 | 4.96e-16 |
| Cut from Device | 1.7e-17 | 5.3e-19 | 1.4e-18 | 3.2e-18 | 2.9e-17 | 8.6e-17 | 4.9e-16 |

(FIRST EMBODIMENT)

Fig. 1 is a section of a thyristor as the first embodiment of a pressure contact type power semiconductor device according to the invention. In Fig. 1, the reference numeral 1 denotes a n-type base layer, 2 denotes a p-type base layer, 3 denotes a p-type emitter layer, 4 denotes a n-type a n-type emitter layer, 5 denotes a first passivation film, 6 denotes a cathode electrode, 7 denotes an anode electrode and 8 denotes a second passivation film.

A fabrication process of the shown embodiment of the thyristor will be discussed with reference to Figs. 4A to 4D. At first, on a high resistance n-type silicon, the p-type base layer 2, the p-type emitter layer 3 and the n-type emitter layer 4 are diffused to form a semiconductor substrate (Fig. 4A). Then, by photoresist process, the n-type emitter layer 4a of a main thyristor, the n-type emitter layer 4b of an auxiliary thyristor and the n-type emitter layer 4c of a photosensitive portion thyristor are formed, respectively. Next, the cathode electrode 6 and the anode electrode 7 are formed by deposition (Fig. 4B). The end portion 16 of the semiconductor substrate are processed into substantially Σ contour with a double positive bevel by means of a grinding machine, sand blaster and so forth. Thereafter, for removing chiping and/or contamination on the side portion 16 of the semiconductor substrate 18, the exposed portion of the semiconductor substrate is subject to chemical etching. After washing and drying, the first passivation film resin is applied on the side portion 16 by spin coating, dip coating, brush application, dispenser and so forth. Subsequently, drying of the resin layer was performed with a 80 °C of hot plate 19 shown in Fig. 9 for 5 minutes. Then, the resin is heated for curing under nitrogen atmosphere to form the first passivation film 5 (Fig. 4C). In the shown embodiment, the first passivation film 5 is made of polyimide (Shinetsu Kagaku Kogyo K.K. KJR652) which has a curing condition of 1 hour at 100 °C, 1 hour at 150 °C and 4 hours at 250 °C. The first passivation film cured in the foregoing curing condition has a conductivity of 1.66 x $10^{-17}$ [ S/cm]. The resin has a glass transition temperature of 240 °C (differential scanning calorimeter: DSC). A thickness of the first passivation layer 5 made of polyimide becomes maximum at a side surface of n-base layer 1 and is preferably more than 5 µm so that occurrence of crack due to heat cycle can be prevented. A region where most electrical field concentrates in the side surface of the base layer having a low impurity concentration is at a point of inflection of the double positive bevel structure, i.e., in the center of Σ contour. Therefore, a film thickness of the first passivation film at this point of inflection is preferably more than 10 µm, and more preferably in a range of 30-100 µm. A thickness at this point of inflection according to this embodiment is 55 µm - 65 µm, which, however, may vary depending on poise of a coating resin, coating methods and drying methods. The thickness of the first passivation film 5 decreases as it moves away from the center portion of the Σ contour and may become as thin as 1 µm at the side surfaces of p-base layer 2 and p-emitter layer 3. Next, on the surface of the first passivation film 5, a resin for forming the second passivation film is poured in a die to form the second passivation film 8 through heating curing. The first embodiment of the semiconductor device is thus fabricated (Fig. 4D). The second passivation film 8 is formed of an addition reaction type silicon rubber (Shinetsu Kagaku Kogyo K. K., KJR9060) which has a curing condition of 1 hour at 100 °C, 1 hour at 150 °C and 2 hours at 250 °C. The conductivity of the silicon rubber cured in the condition set forth above is 1.42 x $10^{-18}$ [S/cm]. Finally, the semiconductor element thus fabricated is packed in a ceramic package (not shown). Interior of the ceramic package is made dry nitrogen atmosphere, and sealed for completing the semiconductor device. A current-voltage characteristics of the shown embodiment of the semiconductor device is shown in Fig. 5.

(SECOND EMBODIMENT)

The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying of the resin layer was performed with a 80 °C of hot plate shown in Fig. 8 for 5 minutes. Then, the resin was heated for curing under dry nitrogen atmosphere to form the first passivation film 5. The curing condition was 1 hour at 100 °C, 1 hour at 150 °C and 4 hours at 250 °C. The first passivation film cured in the foregoing curing condition had a conductivity of 1.66 x 10 $10^{-17}$ [S/cm]. The resin had a glass transition temperature of 240 °C (differential scanning calorimeter: DSC). A thickness of the first passivation film 5 becomes maximum at the double positive bevel junction of n-type base layer 1, which thickness is preferably 55-65 µm. Next, on the surface of the first passivation film 5, a resin for forming the second passivation film was poured in a die to form the second passivation film 8 through heating curing. The second embodiment of the semiconductor device was thus fabricated. The second passivation film 8 was formed of an addition reaction type silicon rubber (Shinetsu Kagaku Kogyo K. K., KJR9063) which had a curing condition of 1 hour at 100 °C, 1 hour at 150 °C and 2 hours at 200 °C. The conductivity of the silicon rubber cured in the condition set forth above was 3.18 x $10^{-18}$ [S/cm]. Finally, the semiconductor element thus fabricated was packed in a ceramic package (not shown). Interior of the ceramic package was made dry nitrogen atmosphere, and sealed for completing the semiconductor device. A current-voltage characteristics of the shown embodiment of the semiconductor device is shown in Fig. 5.

(THIRD EMBODIMENT)

The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying of the resin layer was performed with a 80 °C of hot plate shown in Fig. 8 for 5 minutes. Then, the resin was heated for curing under dry nitrogen atmosphere to form the first passivation film 5. The curing condition was 1 hour at 100 °C, 1 hour at 150 °C and 4 hours at 250 °C. The first passivation film cured in the foregoing curing condition had a conductivity of 1.66 x $10^{-17}$ [S/cm]. The resin had a glass transition temperature of 240 °C (differential scanning calorimeter: DSC). A thickness of the first passivation film 5 becomes maximum at the double positive bevel junction of n-type base layer 1, which thickness is preferably 55-65 µm. Next, on the surface of the first passivation film 5, a resin for forming the second passivation film was poured in a die to form the second passivation film 8 through heating curing. The third embodiment of the semiconductor device was thus fabricated. The second passivation film 8 was formed of an addition reaction type silicon rubber (Shinetsu Kagaku Kogyo K. K., KJR9025) which had a curing condition of 2 hour at 80 °C, 1 hour at 150 °C and 2 hours at 200 °C. The conductivity of the silicon rubber cured in the condition set forth above was 2.94 x $10^{-17}$ [S/cm]. Finally, the semiconductor element thus fabricated was packed in a ceramic package (not shown). Interior of the ceramic package was made dry nitrogen atmosphere, and sealed for completing the semiconductor device. A current-voltage characteristics of the shown embodiment of the semiconductor device is shown in Fig. 5.

(FOURTH EMBODIMENT)

The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying of the resin layer was performed with a 80 °C of hot plate shown in Fig. 8 for 5 minutes. Then, the resin was heated for curing under dry nitrogen atmosphere to form the first passivation film 5. The curing condition was 1 hour at 100 °C, 1 hour at 150 °C and 4 hours at 250 °C. The first passivation film cured in the foregoing curing condition had a conductivity of 1.66 x $10^{-17}$ [S/cm]. The resin had a glass transition temperature of 240 °C (differential scanning calorimeter: DSC). A thickness of the first passivation film 5 becomes maximum at the double positive bevel junction of n-type base layer 1, which thickness is preferably 55-65 µm. Next, on the surface of the first passivation film 5, a resin for forming the second passivation film was poured in a die to form the second passivation film 8 through heating curing. The fourth embodiment of the semiconductor device was thus fabricated. The second passivation film 8 was formed of an addition reaction type silicon rubber (Dow Corning Silicon K. K., JCR6121) which had a curing condition of 1 hour at 100 °C, 1 hour at 150 °C and 2 hours at 200 °C. The conductivity of the silicon rubber cured in the condition set forth above was 8.70 x $10^{-18}$ [S/cm]. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 5.

(FIFTH EMBODIMENT)

The fifth embodiment of the semiconductor device is illustrated in Fig. 6. The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying of the resin layer was performed with a 80 °C of hot plate shown in Fig. 8 for 5 minutes. Then, the resin was heated for curing at the curing condition 1 hour at 100 °C, 1 hour at 150 °C and 4 hours at 250 °C, under dry nitrogen atmosphere to form the first passivation film 5. On the surface of the passivation film 5, a varnish of the same composition was applied in the similar manner for form the passivation films 5 and 11. The first passivation films 5 and 11 cured in the foregoing curing condition had a conductivity of 1.66 x $10^{-17}$ [S/cm]. The resin had a glass transition temperature of 240 °C (differential scanning calorimeter: DSC). A thickness of the first passivation film 5 becomes maximum at the double positive bevel junction of n-type base layer 1, which thickness is preferably 55-65 µm. Next, on the surface of the first passivation film 11, a resin for forming the second passivation film was poured in a die to form the second passivation film 8 through heating curing. The fifth embodiment of the semiconductor device was thus fabricated. The second passivation film 8 was formed of an addition reaction type silicon rubber (Shinetsu Kagaku Kogyo K. K., KJR9063) which had a curing condition of 1 hour at 100 °C, 1 hour at 150 °C and 2 hours at 200 °C. The conductivity of the silicon rubber cured in the condition set forth above was 3.18 x $10^{-18}$ [S/cm]. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 5.

(SIXTH EMBODIMENT)

The sixth embodiment of the semiconductor device is illustrated in Fig. 7. The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying and curing of the resin layer was performed with hot plats set at various temperature as shown in Fig. 10 and by placing the semiconductor substrate applied the first passivation layer on respective hot plates in ascending order of the temperature. The temperatures of the hot plates and shelf periods are respectively 5 minutes at 80 °C, 5 minutes at 150 °C and five minutes at 250 °C. The first passivation film 5 cured in the foregoing curing condition had a conductivity of 1.75 x $10^{-17}$ [S/cm]. The resin had a glass transition temperature of 240 °C (differential scanning calorimeter: DSC). A thickness of the first passivation film 5 becomes maximum at the double positive bevel junction of n-type base layer 1, which thickness is preferably 55-65 µm. Next, on the surface of the first passivation film 11, a resin for forming the second passivation film was poured in a die to form the second passivation film 8 through heating curing. The sixth embodiment of the semiconductor device was thus fabricated. The second passivation film 8 was formed of an addition reaction type silicon rubber (Shinetsu Kagaku Kogyo K. K., KJR9063) which had a curing condition of 1 hour at 100 °C, 1 hour at 150 °C and 2 hours at 200 °C. The conductivity of the silicon rubber cured in the condition set forth above was 3.15 x $10^{-18}$ [S/cm]. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 5.

(SEVENTH EMBODIMENT)

The seventh embodiment of the semiconductor device is illustrated in Fig. 8. The semiconductor substrate was processed in the similar manner to the first embodiment. After chemical etching, washing and drying, SiN film 17 as the first passivation film was formed by plasma CVD method. The first passivation film 17 has a thickness of 1 μm and a conductivity of 2.22 X $10^{-16}$ [S/cm]. Then, on the first passivation film 17, the second passivation film resin (Shinetsu Kagaku Kogyo K.K., KJR652) was applied by spin coating. Subsequently, drying of the resin layer was performed with a 80 °C of hot plate shown in Fig. 9 for 5 minutes. Then, the resin was heated for curing at the curing condition 1 hour at 100 °C 1 hour at 150 °C and 4 hours at 250 °C, under dry nitrogen atmosphere to form the second passivation film 11. The second passivation film 11 cured in the foregoing curing condition had a conductivity of 1.66 x $10^{-17}$ [S/cm]. The resin had a glass transition temperature of 240 °C (differential scanning calorimeter: DSC). A thickness of the first passivation film 5 beomes maximum at the double positive bevel junction of n-type base layer 1, which thickness is preferably 55-65 μm. Next, on the surface of the second passivation film 11, a resin for forming the third passivation film was poured in a die to form the third passivation film 8 through heating curing. The seventh embodiment of the semiconductor device was thus fabricated. The second passivation film 8 was formed of an addition reaction type silicon rubber (Shinetsu Kagaku Kogyo K. K., KJR9063) which had a curing condition of 1 hour at 100 °C, 1 hour at 150 °C and 2 hours at 200 °C. The conductivity of the silicon rubber cured in the condition set forth above was 3.15 x $10^{-18}$ [S/cm]. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 5.

(EIGHTH EMBODIMENT)

The eighth embodiment of the semiconductor device is illustrated in Fig. 14. In the shown embodiment, the passivation layers in the second embodiment was applied to a gate turn-OFF thyristor (GTO). In the drawing of Fig. 14, numeral 12 depicts a gate electrode, and 13 depicts $n^+$ layer.

The fabrication process of the passivation film was the same as that of the second embodiment, in which the semiconductor substrate was processed, chemically etched, washed and dried, subsequently, the first passivation film 5 was formed, and the second passivation film 8 was formed. Finally, the semiconductor element was packed in the ceramic package (not shown), the inferior atmosphere of the package was made to be dry nitrogen atmosphere, and thereafter the package was sealed to form the semiconductor device.

(NINTH EMBODIMENT)

The ninth embodiment of the semiconductor device according to the present invention is illustrated in Fig. 15. In the shown embodiment, the passivation layers in the second embodiment was applied to a diode. In Fig. 15, numeral 14 depicts $p^+$ layer, and 15 depicts $n^-$ layer.

The fabrication process of the passivation film was the same as that of the second embodiment, in which the semiconductor substrate was processed, chemically etched, washed and dried, subsequently, the first passivation film 5 was formed, and the second passivation film 8 was formed. Finally, the semiconductor element was packed in the ceramic package (not shown), the interior atmosphere of the package was made to be dry nitrogen atmosphere, and thereafter the package was sealed to form the semiconductor device.

With respect to the eighth and ninth embodiments of semiconductor devices, a DC blocking test as long period reliability test was performed. The test condition was to continuously apply voltages which are 75% of rated voltages of respective elements, at junction temperature 125 °C for 168 hours. As a results, it had been found that the current-voltage characteristics after test was held unchanged to that before test. Thus, it had been demonstrated that the elements in the eighth and ninth embodiments achieve quite high reliability.

(FIRST COMPARATIVE EXAMPLE)

The semiconductor substrate was processed in the similar manner to the first embodiment. After chemical etching, washing and drying, the first passivation film resin was applied on the end portion 16 by spin coating. Subsequently, drying of the resin layer was performed with a 80 °C of hot plate shown in Fig. 8 for 5 minutes. Then, the resin was heated for curing under dry nitrogen atmosphere to form the first passivation film 5. The first passivation film 5 was formed of polyimide (Shinetsu Kagaku Kogyo K. K.. KJR652), having the curing condition 1 hour at 100 °C, 1 hour at 150 °C and 4 hours at 250 °C. The first passivation film cured in the foregoing curing condition had a conductivity of 1.66 x $10^{-17}$ [S/cm]. The resin had a glass transition temperature of 240 °C (differential scanning calorimeter: DSC). Next, on the surface of the first passivation film 5, a resin for forming the second passivation film was poured in a die to form the second passivation film 8 through heating curing. The comparative example of the semiconductor device was thus fabricated. The second passivation film 8 was formed of an addition reaction type silicon rubber (Shinetsu Kagaku Kogyo K. K., KJR9028) which had a curing condition of 1 hour at 100 °C, 1 hour at 150 °C and 2 hours at 200 °C. The conductivity of the silicon rubber cured in the condition set forth above was 5.32 x $10^{-19}$ [S/cm]. Finally, the semiconductor element thus fabricated was packed in a ceramic package (not shown). Interior of the ceramic package was made dry nitrogen atmosphere, and sealed for completing the semiconductor device. A current-voltage characteristics of the shown embodiment of the semiconductor device is shown in Fig. 5.

(SECOND COMPARATIVE EXAMPLE)

The semiconductor substrate was processed in the similar manner to the first embodiment. After chemical etching, washing and drying, the first passivation film resin (Shinetsu Kagaku Kogyo K.K., KJR652) was applied on the end portion 16 by spin coating. Subsequently, drying of the resin layer was performed with a 80 °C of hot plate shown in Fig. 8 for 5 minutes. Then, the resin was heated for curing under dry nitrogen atmosphere to form the first passivation film 5. The curing condition was 1 hour at 100 °C, 1 hour at 150 °C and 4 hours at 250 °C. The first passivation film cured in the foregoing curing condition had a conductivity of 1.66 x $10^{-17}$ [S/cm]. The resin had a glass transition temperature of 240 °C (differential scanning calorimeter: DSC). Next, on the surface of the first passivation film 5, a resin for forming the second passivation film was poured in a die to form the second passivation film 8 through heating curing. The second comparative example of the semiconductor device was thus fabricated. The second passivation film 8 was formed of an addition reaction type silicon rubber (Toshiba Silicon K. K., TSJ3150) which had a curing condition of 1 hour at 100 °C, 1 hour at 150 °C and 2 hours at 200 °C. The conductivity of the silicon rubber cured in the condition set forth above was 4.96 x $10^{-16}$ [S/cm]. Finally, the semiconductor element thus fabricated was packed in a ceramic package (not shown). Interior of the ceramic package was made dry nitrogen atmosphere, and sealed for completing the semiconductor device. A current-voltage characteristics of the shown embodiment of the semiconductor device is shown in Fig. 5.

The current-voltage characteristics between the anode electrode and the cathode electrode of the first, second, third, fourth and fifth embodiments and first and second comparative examples are shown in Fig. 5. As can be seen from Fig. 5, the current-voltage characteristics of the first and second comparative examples increases the leakage current from the initial stage of charging of voltage. This is because expansion of the depletion layer in the end surface of the p-n junction applied the reverse bias becomes abnormal to cause large leakage current therethrough. As a result, an intended breakdown voltage cannot be achieved to cause characteristics failure. In contrast to this, in the first, second, third and fourth embodiments, increasing of the leakage current as observed in the first comparative example, was never observed, and good characteristics was demonstrated.

With respect to the first, second, third, fourth and fifth embodiments and first and second comparative examples of semiconductor devices, a DC blocking test as long period reliability test was performed. The test condition was to continuously apply voltages which are 75% of rated voltages of respective elements, at junction temperature 125 °C for 168 hours. The first and second comparative examples have been broken after about 5 hours from initiation of test. In contrast to this, in the first, second, third and fourth embodiments, the test was successfully completed without causing any variation of the leakage current. As a results, it had also been found that the current-voltage characteristics after test was held unchanged to that before test. Thus, it had been demonstrated that the elements in the first, second, third and fourth embodiments achieve quite high reliability.

(THIRD COMPARATIVE EXAMPLE)

The third comparative example of the semiconductor device is illustrated in Fig. 11. The semiconductor substrate was processed in the similar manner to the first embodiment. After chemical etching, washing and drying, the first passivation film resin was applied on the end portion 16 by spin coating. Subsequently, the resin layer was headed and cured within a high temperature vessel under nitrogen atmosphere to form the first passivation layer. The first passivation film is formed of (Shinetsu Kagaku Kogyo K.K., KJR652) which has a curing condition of 1 hour at 100 °C, 1 hour at 150 °C and 4 hours at 250 °C. The first passivation film 5 cured in the foregoing curing condition had a conductivity of 1.76 x $10^{-17}$ [S/cm]. The resin had a glass transition temperature of 240 °C (differential scanning calorimeter: DSC). Next, on the surface of the first passivation film 11, a resin for forming the second passivation film was poured in a die to form the second passivation film 8 through heating curing. The sixth embodiment of the semiconductor device was thus fabricated. The second passivation film 8 was formed of an addition reaction type silicon rubber (Shinetsu Kagaku Kogyo K. K., KJR9063) which had a curing condition of 1 hour at 100 °C, 1 hour at 150 °C and 2 hours at 200 °C. The conductivity of the silicon rubber cured in the condition set forth above was 5.32x $10^{-19}$ [S/cm]. The first passivation film 5 of the semiconductor fabricated as set forth above, has been cured in a condition flowing downward to the lower side by gravity. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 12.

The current-voltage characteristics upon application of positive voltage to the anode electrodes and negative voltage to the cathode electrodes of the semiconductor devices of the sixth embodiment and the third comparative example. As can be clear from Fig. 12, the current-voltage characteristics of the third comparative example has greater leakage current than that of the sixth embodiment.

With respect to the sixth and the third comparative example of semiconductor devices, a DC blocking test as long period reliability test was performed. The test condition was to continuously apply voltages which are 75% of rated voltages of respective elements, at junction temperature 125 °C for 168 hours. After test, the current-voltage characteristics of the third comparative example was degraded. On the other hand, the current-voltage characteristics after test was held unchanged to that before test, in the sixth embodiment. Thus, it had been demonstrated that the elements in the sixth embodiment achieve quite high reliability.

(FOURTH COMPARATIVE EXAMPLE)

The semiconductor substrate was processed in the similar manner to the first embodiment. After chemical etching, washing and drying, the first passivation film resin was applied on the end portion 16 by spin coating. Subsequently, the resin layer was headed and cured within an oven under dry nitrogen atmosphere to form the first passivation layer. The first passivation film is formed of (Shinetsu Kagaku Kogyo K.K., KJR652) which has a curing condition of 1 hour at 100 °C, 1 hour at 150 °C and 4 hours at 250 °C. The first passivation film 5 cured in the foregoing curing condition had a conductivity of 1.76 x $10^{-17}$ [S/cm]. The resin had a glass transition temperature of 240 °C (differential scanning calorimeter: DSC). Next, on the surface of the first passivation film 11, a resin for forming the second passivation film was poured in a die and cured by leaving in a humidifier at room temperature to provide humidity of 95% for 40 hours. After removing from the die, heat treatment was provided for forming the second passivation film 8. The fourth comparative example of the semiconductor device was thus fabricated. The second passivation film 8 was formed of an condensation reaction type silicon rubber (Shinetsu Kagaku Kogyo K. K., KJR4013) which had a curing condition Of 1 hour at 100 °C, 1 hour at 150 °C and 2 hours at 200 °C. The conductivity of the silicon rubber cured in the condition set forth above was 2.35x $10^{-17}$ [S/cm]. Finally, the semiconductor element thus fabricated was packed in a ceramic package. Interior of the ceramic package was made dry nitrogen atmosphere, and sealed for completing the semiconductor device. A current-voltage characteristics of the shown embodiment of the semiconductor device is shown in Fig. 12. The current-voltage characteristics of the shown fourth comparative example before and after the DC blocking test is shown in Fig. 13. The test was performed by leaving the semiconductor device at 150 °C for 168 hours. After test, the current-voltage characteristics of the fourth comparative example was degraded. Thus, it had been found that the elements of the fourth comparative example has poor long period reliability.

(TENTH EMBODIMENT)

Fig. 16 shows one example wherein the high voltage semiconductor device according to the present invention is applied for an external rectifier circuit. VR, VS and VT represent three-phase alternating voltages, T denotes a thyristor element, R denotes a resistor, L denotes a reactor. A plurality of stages of thyristor elements T are connected in series so that a required breakdown voltage as a valve can be satisfied. In each of the individual thyristor element T, for uniformly sharing voltage between the elements, a capacitor C and a resistor R are connected in parallel. By such three-phase bridge rectifier circuit, three-phase alternating voltage VR, VS and VT are converted into direct current.

(ELEVENTH EMBODIMENT)

Fig. 17 shows an example wherein the high voltage semiconductor device according to the present invention is applied to an external inverter circuit. E denotes a direct current source, VU, VV, VW are load side of three-phase alternating voltages, T denote thyristors and L denotes a reactor. A plurality of stages of thyristor elements T are connected in series so that a required breakdown voltage as a valve can be satisfied. In each of the individual thyristor element T, for uniformly sharing voltage between the elements, a capacitor C and a resistor R are connected in parallel. By such three-phase bridge rectifier circuit, the direct current power source E is converted into three-phase alternating voltage VU, VV and VW.

(TWELFTH EMBODIMENT)

Fig. 18 shows one example wherein the high voltage semiconductor device according to the present invention is applied to an external cycloconverter circuit. E denotes a direct current source, VR, VS, VT are load side of three-phase alternating voltages, T denote thyristors, R denotes a resistor and L denotes a reactor. A plurality of stages of thyristor elements T are connected in series so that a required breakdown voltage as a valve can be satisfied. In each of the individual thyristor element T, for uniformly sharing voltage between the elements, a capacitor C and a resistor R are connected in parallel. By anti-parallel connection of such three-phase bridge rectifier circuit, an output waveform can be controlled so that a sine wave form output voltage current can be obtained. Therefore, an output frequency can be converted to be 3/1 or 6/1 to an input frequency.

(THIRTEENTH EMBODIMENT)

Fig. 19 shows an example, in which the diode of the present invention is applied for a snubber circuit in the gate turn-OFF thyristor. In Fig. 19, GTO denotes a gate turn-OFF thyristor connected between terminale T1 and T2, DS and CS are snubber diode and snubber capacitor connected in series to each other and connected in parallel with the gate turn-OFF transistor GTO, RS is a snubber resistor connected in parallel to the snubber diode DS. In Fig. 9, LL depicts a load inductance, LS depicts inductance of the snubber circuit, and LSS depicts inductance included in snubber resistance RS.

(FOURTEENTH EMBODIMENT)

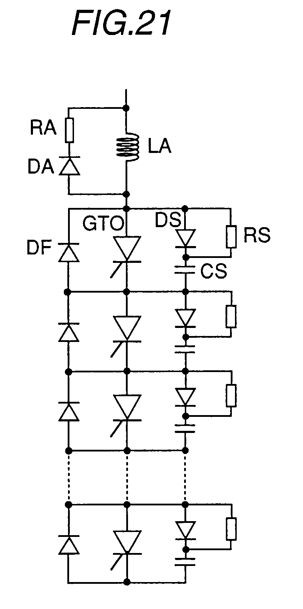

Fig. 20 shows an example, in which the diode and the gate turn-OFF transistor of the present invention are applied to a voltage type inverter. In Fig. 20, 30 denotes a gate turn-OFF thyristors (GTO) forming direct current connection and connected in parallel between a pair of direct current terminals T3 and T4 in number corresponding to number of phases of the alternating current, 40 denotes diodes connected to respective GTO in anti-parallel fashion for reducing load current, T5, T6, T7 denotes alternating current terminals connected to junctions of series connection. Normally, in a large capacity inverter, the breakdown voltage is lower than a required voltage, a plurality of GTOs 30 and the diodes 40 are used by connecting the GTO elements and the diode elements in series, as shown in Fig. 21. In the series connection circuit of Fig. 21, LA denotes an anode reactor, RA denotes current decreasing resistor, DA denotes feedback diode of anode reactor circuit, DF denote diodes reducing load current. DS, RS and CS denote snubber diode, snubber resistor and snubber capacitor, respectively. With employing the high voltage semiconductor device of the present invention in a power inverter shown in Figs. 16, 17, 18, 19, 20 and 21 high reliability of the system can be achieved.

(FIFTEENTH EMBODIMENT)

In the first embodiment, semiconductor substrates having 1050, 1400, 1700 and 1950 μm of the thickness of n-type base layer are fabricated. These semiconductor substrates are processed similarly to the second embodiment. After processing, etching and formation of passivation layer, the semiconductor element is packed with a ceramic package. After filling dry nitrogen, the package is sealed to complete the semiconductor device. The breakdown voltages (peak repetitive reverse voltage, peak repetitive OFF voltage) of these semiconductor devices 6, 8, 10 12 kV, respectively.

Although the invention has been illustrated and described with respect to exemplary embodiment thereof, it should be understood by those skilled in the art that the foregoing and various other changes, omissions and additions may be made therein and thereto, without departing from the spirit and scope of the present invention. Therefore, the present invention should not be understood as limited to the specific embodiment set out above but to include all possible embodiments which can be embodies within a scope encompassed and equivalents thereof with respect to the feature set out in the appended claims.

## Claims

1. A semiconductor device having a semiconductor substrate having a main surface and an opposite surface and at least one p-n junction exposed partially to a side surface of the substrate and a multi-layered structure of passivation films (5, 8, 11, 17) having two or more passivation films coated on the side surface of said semiconductor substrate, wherein an interface polarization charge Qr (coulomb/cm$^2$) induced in the vicinity of an interface between a first passivation film provided on the surface of said semiconductor substrate and a second passivation film provided on the surface of said first passivation film is in a relationship expressed by equation 1,

$$1.6 \times 10^{-8} \geq |Qr| \qquad (1).$$

2. A semiconductor device having a semiconductor substrate having a main surface and an opposite surface and at least one p-n junction exposed partially to a side surface of the substrate and a multi-layered structure of passivation films (5, 8, 11, 17) having two or more passivation films coated on the side surface of said semiconductor substrate, wherein a conductivity $\sigma_1$ of a first passivation film provided on the surface of said semiconductor substrate and a conductivity $\sigma_2$ of a second passivation film provided on the surface of said first passivation film satisfy

$$0.05 \leq \sigma_2/\sigma_1 \leq 10 \qquad (2).$$

**3.** A semiconductor device having a semiconductor substrate having a main surface and an opposite surface and at least one p-n junction exposed partially to a side surface of the substrate and a multi-layered structure of passivation films (5, 8, 11, 17) having two or more passivation films coated on the side surface of said semiconductor substrate, wherein an interface polarization Qr (coulomb/cm$^2$) induced in the vicinity of an interface between a first passivation film provided on the surface of said semiconductor substrate and a second passivation film provided on the surface of said first passivation film satisfy

$$1.6 \times 10^{-8} \geq |Qr| \quad (1),$$

and wherein a conductivity $\sigma_1$ of said first passivation film and a conductivity $\sigma_2$ of said second passivation film satisfy

$$0.05 \leq \sigma_2/\sigma_1 \leq 10 \quad (2).$$

**4.** A semiconductor device having a semiconductor substrate having a main surface and an opposite surface and at least one p-n junction exposed partially to a side surface of the substrate and a multi-layered structure of passivation films (5, , 11, 17) having two or more films coated on the side surface of said semiconductor substrate, wherein a conductivity $\sigma_1$ of a first passivation film provided on the surface of said semiconductor substrate and a conductivity $\sigma_2$ of a second passivation film provided on the surface of said first passivation film satisfy

$$0.05 \leq \sigma_2/\sigma_1 \leq 10 \quad (2),$$

and wherein a maximum rated voltage of said semiconductor device is higher than or equal to 8 kV.

**5.** A semiconductor device having a semiconductor substrate having a main surface and an opposite surface and at least one p-n junction exposed partially to a side surface of the substrate and a multi-layered structure of passivation films (5, 8, 11, 17) having two or more passivation films coated on the side surface of said semiconductor substrate, wherein an interface polarization charge Qr (coulomb/cm$^2$) induced in the vicinity of an interface between a first passivation film provided on the surface of said semiconductor substrate and a second passivation film provided on the surface of said first passivation film satisfy

$$1.6 \times 10^{-8} \geq |Qr| \quad (1),$$

wherein a conductivity $\sigma_1$ of said first passivation film and a conductivity $\sigma_2$ of said second passivation film satisfy

$$0.05 \leq \sigma_2/\sigma_1 \leq 10 \quad (2).$$

and wherein a maximum rated voltage of said semiconductor device is higher than or equal to 8 kV.

**6.** A semiconductor device having a semiconductor substrate having a main surface and an opposite surface and at least one p-n junction exposed partially to a side surface of the substrate and a multi-layered structure of passivation having two or more passivation films (5, 8, 11, 17) coated on the side surface of said semiconductor substrate, wherein a conductivity $\sigma_1$ of a first passivation film provided on the side surface of said semiconductor substrate and a conductivity $\sigma_2$ of a second passivation film provided on the surface of said first passivation film satisfy

$$0.05 \leq \sigma_2/\sigma_1 \leq 10 \quad (2).$$

and

wherein a thickness of an n-type base layer of said semiconductor substrate is greater than or equal to 100 μm and smaller than or equal to 5000 μm, and a maximum rated voltage of said semiconductor device is higher than or equal to 6 kV.

**7.** A semiconductor device having a semiconductor substrate having a main surface and an opposite surface and at least one p-n junction exposed partially to a side surface of the substrate and a multi-layered structure of passivation having two or more passivation films (5, 8,11, 17) coated on the side surface of said semiconductor substrate, wherein an interface polarization charge Qr (coulomb/cm2) induced in the vicinity of an interface between a first passivation film and a second passivation film provided on the side surface of said semiconductor substrate satisfy

$$1.6 \times 10^{-8} \geq |Qr| \quad (1),$$

wherein a conductivity $\sigma_1$ of a first passivation film provided on the side surface of said semiconductor substrate and a conductivity $\sigma_2$ of a second passivation film provided on the surface of said first passivation film satisfy

$$0.05 \leq \sigma_2/\sigma_1 \leq 10 \qquad (2),$$

and wherein a thickness of an n-type base layer of said semiconductor substrate is greater than or equal to 100 μm and smaller than or equal to 5000 μm, and a maximum rated voltage of said semiconductor device is higher than or equal to 8 kV.

**8.** A semiconductor device as set forth in claim 2 or 3, wherein a thickness of an n-type base layer of said semiconductor substrate is greater than or equal to 100 μm and smaller than or equal to 5000 μm.

**9.** A semiconductor device as set forth in claim 6 or 7, wherein a maximum rated voltage of said semiconductor device is higher than or equal to 6 kV, and a thickness of an n-type base layer of said semiconductor substrate is greater than or equal to 1000 μm and smaller than or equal to 2000 μm.

**10.** A semiconductor device as set forth in any one of claim 1 to 7, wherein said first passivation film provided on the side surface of said semiconductor substrate is formed of an organic material having a glass transition temperature in a range higher than or equal to 150 °C and lower than or equal to 400 °C.

**11.** A semiconductor device as set forth in any one of claims 1 to 7, wherein said second passivation film provided on the surface of said first passivation film is an additive reaction type silicon compound.

**12.** A semiconductor device as set forth in any one of claims 1 to 7, wherein said first passivation film is formed of polyimide.

**13.** A semiconductor device having a semiconductor substrate having a main surface and an opposite surface and at least one p-n junction partially exposed to a side surface and a multi-layered structure of passivation having two or more passivation films (5, 8, 11, 17) coated on the side surface of said semiconductor substrate, wherein a first passivation film provided on the side surface of said semiconductor device is formed of polyimide and a second passivation film provided on the surface of said first passivation film is formed of an additive reaction type silicon compound, a conductivity $\sigma_1$ of said first passivation film and a conductivity $\sigma_2$ of said second passivation film satisfy

$$0.05 \leq \sigma_2/\sigma_1 \leq 10 \qquad (2).$$

**14.** A semiconductor device as set forth in claim 2 or 3, wherein said first passivation film is an inorganic material.

**15.** A semiconductor device as set forth in claim 14, wherein said second passivation film is an additive reaction type silicon compound.

**16.** A semiconductor device as set forth in claim 14, wherein said inorganic material is one of $SiO_2$, SiN, SiC.

**17.** A semiconductor device as set forth in any one of claims 1 to 7, wherein the shape of side surface of said semiconductor substrate is a positive bevel.

**18.** A semiconductor device as set forth in any one of claims 1 to 7, wherein the shape of side surface of said semiconductor substrate is a double positive bevel.

**19.** A semiconductor device as set forth in claim 14, wherein said first passivation film comprises an organic material having a glass transition temperature in a range higher than or equal to 150 °C and lower than or equal to 400 °C .

**20.** A semiconductor device as set forth in claim 14, wherein said second passivation film is an additive reaction type silicon compound.

**21.** A semiconductor device having a semiconductor substrate having a main surface and an opposite surface, at least one p-n junction partially exposed to a side surface of said substrate, which side surface is processed to have a double positive bevel structure, and a multi-layered structure of passivation having two or more passivation films (5, 8, 11, 17) coated on the side surface of said semiconductor substrate, wherein a layer thickness of a first passivation layer provided on said side surface of said semiconductor substrate becomes a maximum value at the side surface of said n-type base layer.

**22.** A semiconductor device having a semiconductor substrate having a main surface and an opposite surface and at least one p-n junction partially exposed to a side surface of said semiconductor substrate which is processed to have a double positive bevel structure, and a multi-layered structure of passivation having two or more passivation films (5, 8, 11, 17) coated on the side surface of said semiconductor substrate, wherein, a high temperature blocking test as a duration test of said semiconductor device is performed by setting said semiconductor device to have a p-n junction temperature of semiconductor element at 100 °C, and a maximum rated voltage of higher than or equal to 6 kV, continuously applying direct current of 70 % of the maximum rated voltage for 1000 hours, and a change of leakage current before and after testing at 25 °C at the maximum rated voltage of said semiconductor device is less than or equal to ±50 %.

**23.** A power converter having an externally-excited rectifier circuit, an externally-excited inverter circuit, an externally-excited cycloconverter circuit, and a voltage-type inverter circuit respectively employing a semiconductor device including a semiconductor substrate having a main surface and an opposite surface and at least one p-n junction partially exposed to a side surface of said semiconductor substrate, and a multi-layered structure of passivation having two or more passivation films (5, 8, 11, 17) coated on the side surface of said semiconductor substrate, wherein a thickness of said n-type base layer of said semiconductor substrate is greater than or equal to log Am and smaller than or equal to 5000 μm, a conductivity $\sigma_1$ of a first passivation film provided on the surface of said semiconductor substrate and a conductivity $\sigma_2$ of a second passivation film provided on the surface of said first passivation film satisfy

$$0.05 \leq \sigma_2/\sigma_1 \leq 10 \qquad (2).$$

**24.** A power converter having a self-excited rectifier circuit, a self-excited inverter circuit, a self-excited cycloconverter circuit, and a voltage-type inverter-circuit respectively employing a semiconductor device including a semiconductor substrate having a main surface and an opposite surface and at least one p-n junction partially exposed to a side surface of said semiconductor substrate, and a multi-layered structure of passivation having two or more passivation films (5, 8, 11, 17) coated on the side surface of said semiconductor substrate, wherein a thickness of said n-type base layer of said semiconductor substrate is greater than or equal to 100 μm and smaller than or equal to 5000 μm, a conductivity $\sigma_1$ of a first passivation film provided on the surface of said semiconductor substrate and a conductivity $\sigma_2$ of a second passivation film provided on the surface of said first passivation film satisfy

$$0.05 \leq \sigma_2/\sigma_1 \leq 10 \qquad (2).$$

**25.** A semiconductor device having a semiconductor substrate having a main surface and an opposite surface, at least one p-n junction partially exposed to a side surface of said semiconductor substrate and a multi-layered structure of passivation having two or more passivation films (5, 8, 11, 17) coated on the side surface of said semiconductor substrate, wherein a maximum rated voltage is higher than or equal to 8 kV and a rated loss is less than or equal to 4000 W.

**26.** A fabrication process of a semiconductor device including steps of: diffusing p-type and n-type semiconductor layers in a semiconductor substrate; processing peripheral portion of said semiconductor substrate into a positive bevel or double positive bevel contours; etching the processed surface: and forming at least one passivation film by applying a passivation resin on the etched surface, wherein the process further comprises the step of removing by spinning an excessive resin of said passivation film which is applied on said surface having been etched before subjecting to heating, drying and hardening such that a film thickness of a first passivation film formed on said side surface of said semiconductor substrate has a maximum thickness on the side of n-base layer.

**27.** A power converter having semiconductor devices according to one of the claims 1 to 22 or formed by the process of claim 26.

**28.** A semiconductor device having a semiconductor substrate having a main surface and an opposite surface and at least one p-n junction exposed partially to a side surface of the substrate and a multi-layered structure of passivation films having two or more passivation films coated on the side surface of said semiconductor substrate, wherein an interface polarization charge Qr (coulomb/$cm^2$) induced in the vicinity of an interface between a first passivation film provided on the surface of said semiconductor substrate and a second passivation film provided on the surface of said first passivation film is in a relationship expressed by equation 1,

$$1.6 \times 10^{-8} \geq |Qr| \quad (1),$$

and wherein a thickness of said first passivation film at a side of a base layer having a low impurity concentration is 5 μm.

**29.** A semiconductor device having a semiconductor substrate having a main surface and an opposite surface and at least one p-n junction exposed partially to a side surface of the substrate and a multi-layered structure of passivation films having two or more passivation films coated on the side surface of said semiconductor substrate, wherein a conductivity $\sigma_1$ of a first passivation film provided on the surface of said semiconductor substrate and a conductivity $\sigma_2$ of a second passivation film provided on the surface of said first passivation film satisfy

$$0.05 \leq \sigma_2/\sigma_1 \leq 10 \quad (2),$$

and wherein a thickness of said first passivation film at a side of a base layer having a low impurity concentration is 5 μm or more.

FIG.1

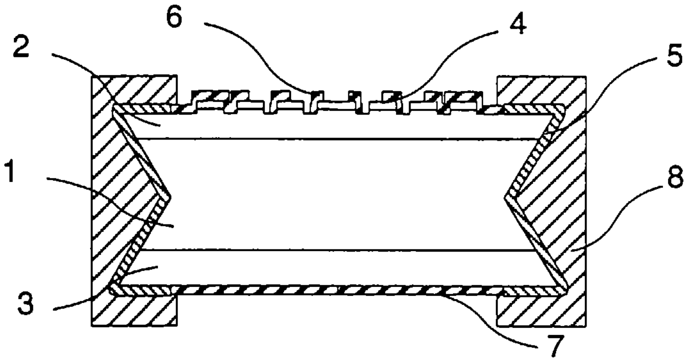


FIG.2

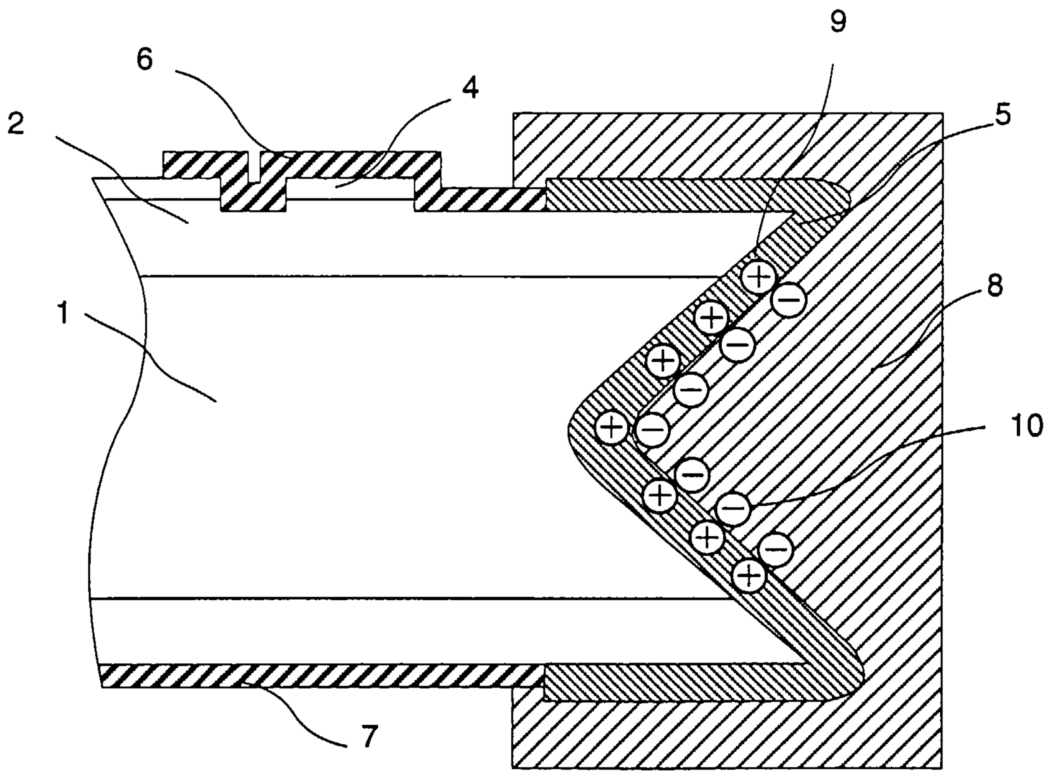

*FIG.3*

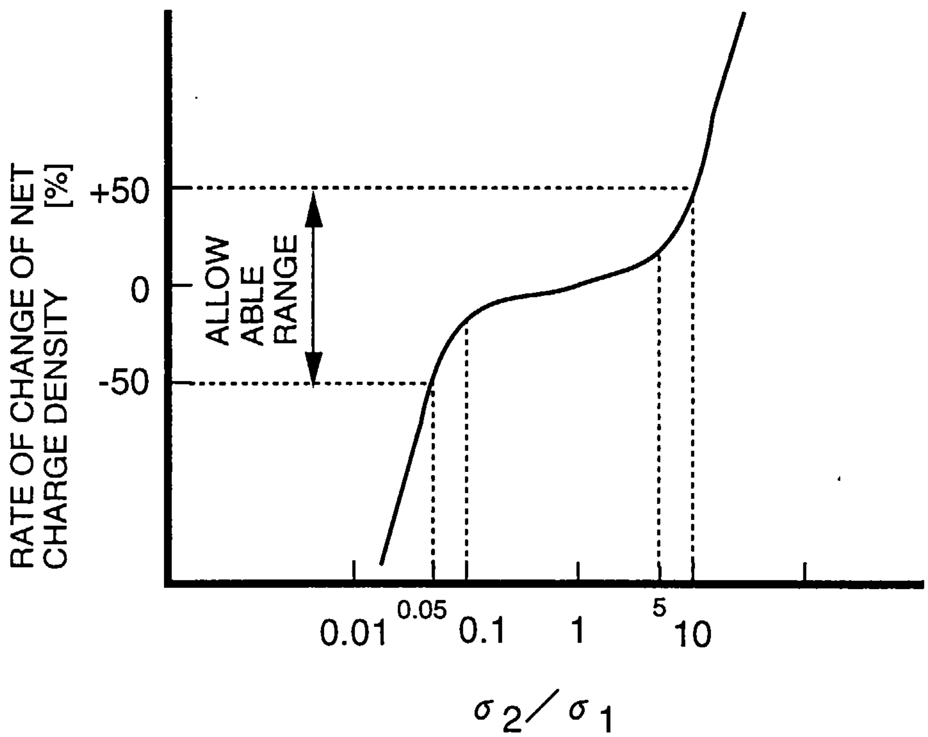
RATE OF CHANGE OF NET CHARGE DENSITY [%]
+50
0
-50
ALLOW ABLE RANGE
0.01
0.05
0.1
1
5
10
σ2/σ1

FIG.4 (A)

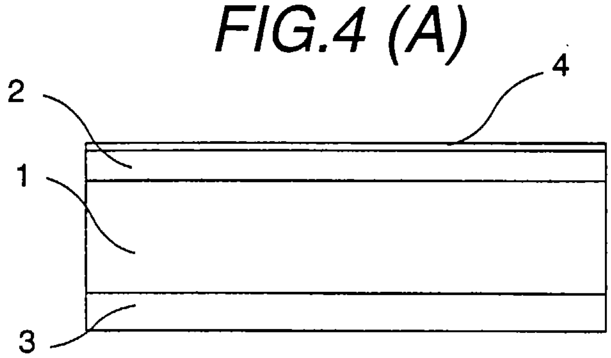


FIG.4 (B)

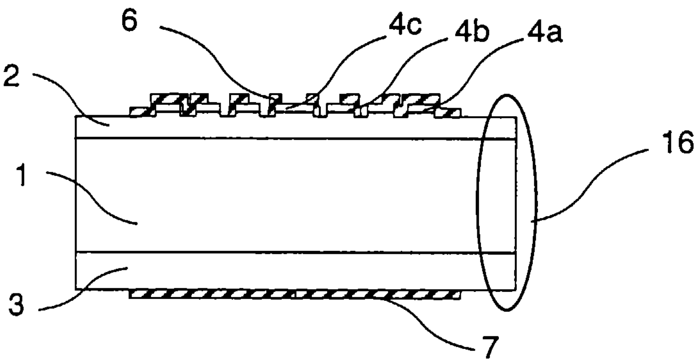


FIG.4 (C)

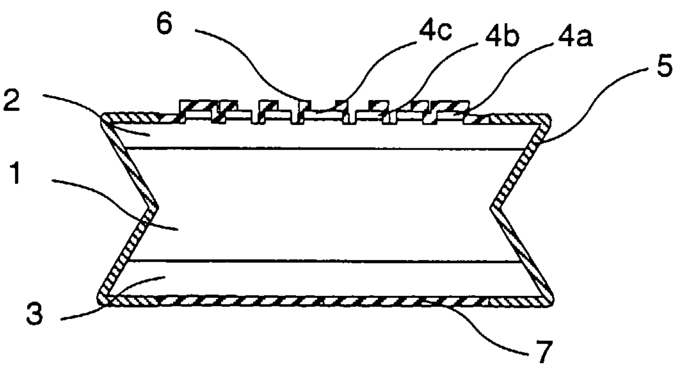


FIG.4 (D)

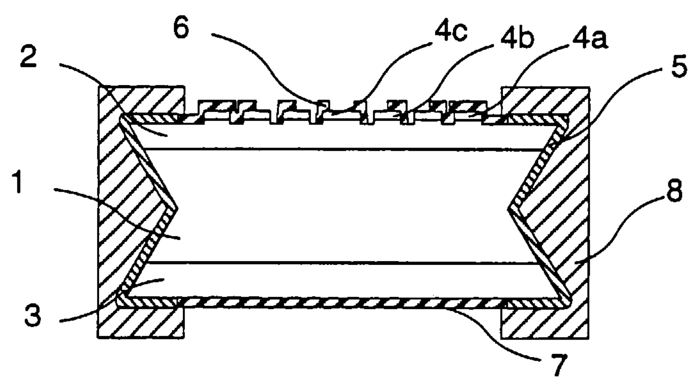

FIG.5

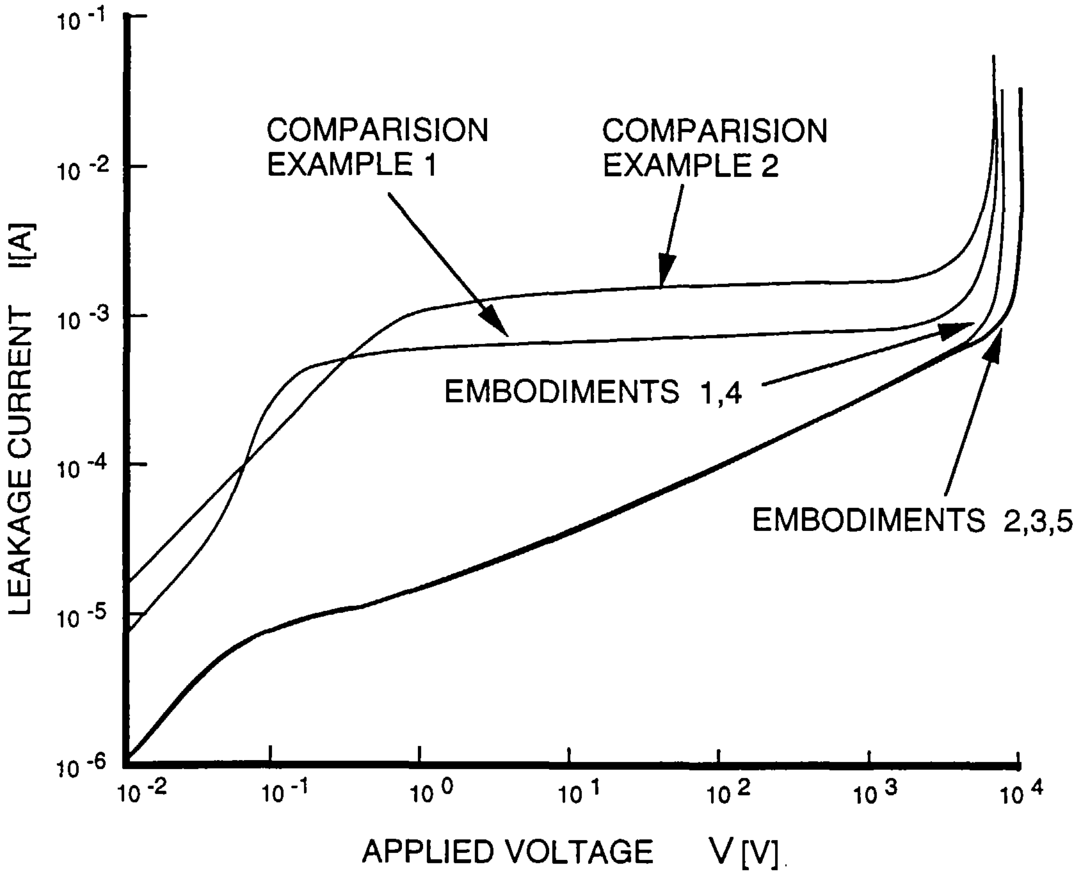
10 -1
10 -2
10 -3
10 -4
10 -5
10 -6
LEAKAGE CURRENT I[A]
COMPARISION EXAMPLE 1
COMPARISION EXAMPLE 2
EMBODIMENTS 1,4
EMBODIMENTS 2,3,5
10 -2
10 -1
10 0
10 1
10 2
10 3
10 4
APPLIED VOLTAGE V [V]

FIG.6

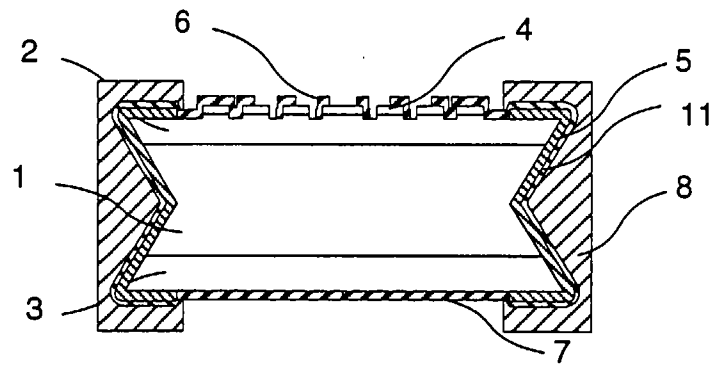


FIG.7

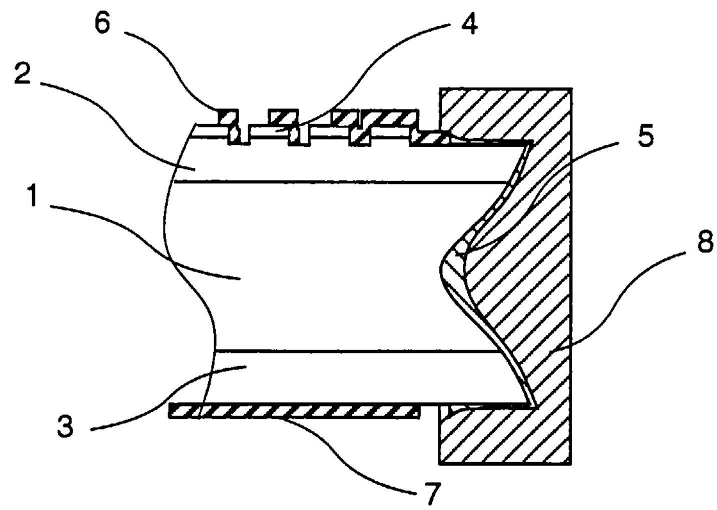

FIG.8

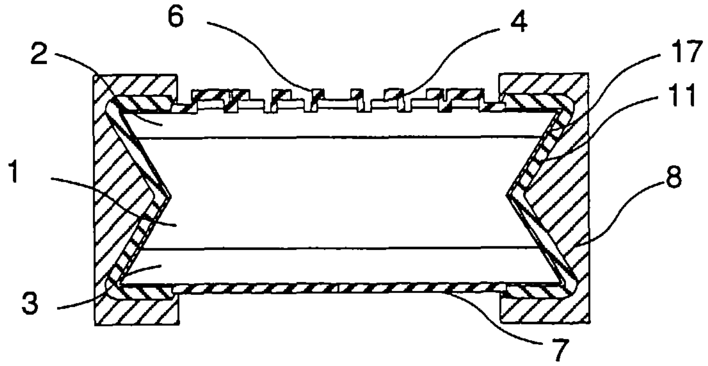


FIG.9

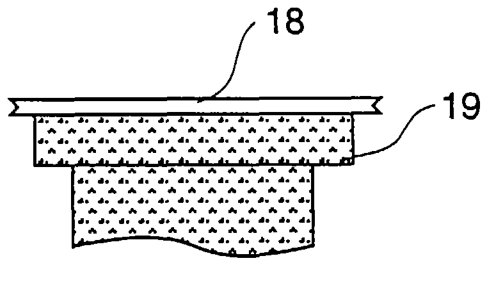

FIG.10

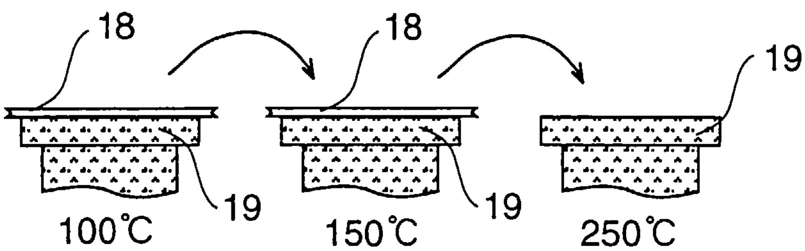


FIG.11

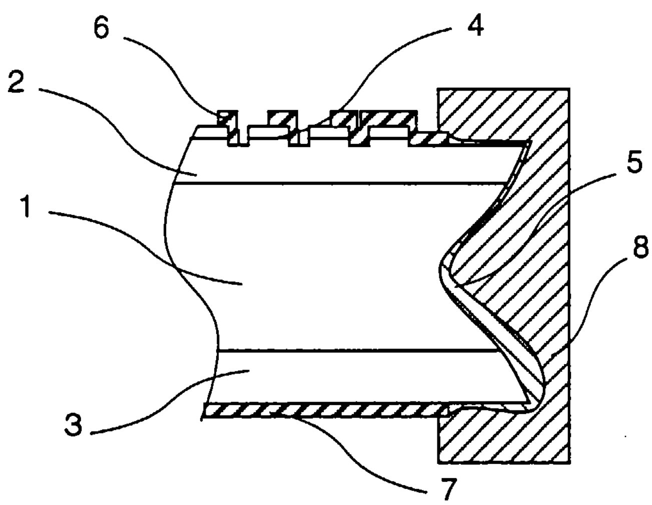

FIG.12

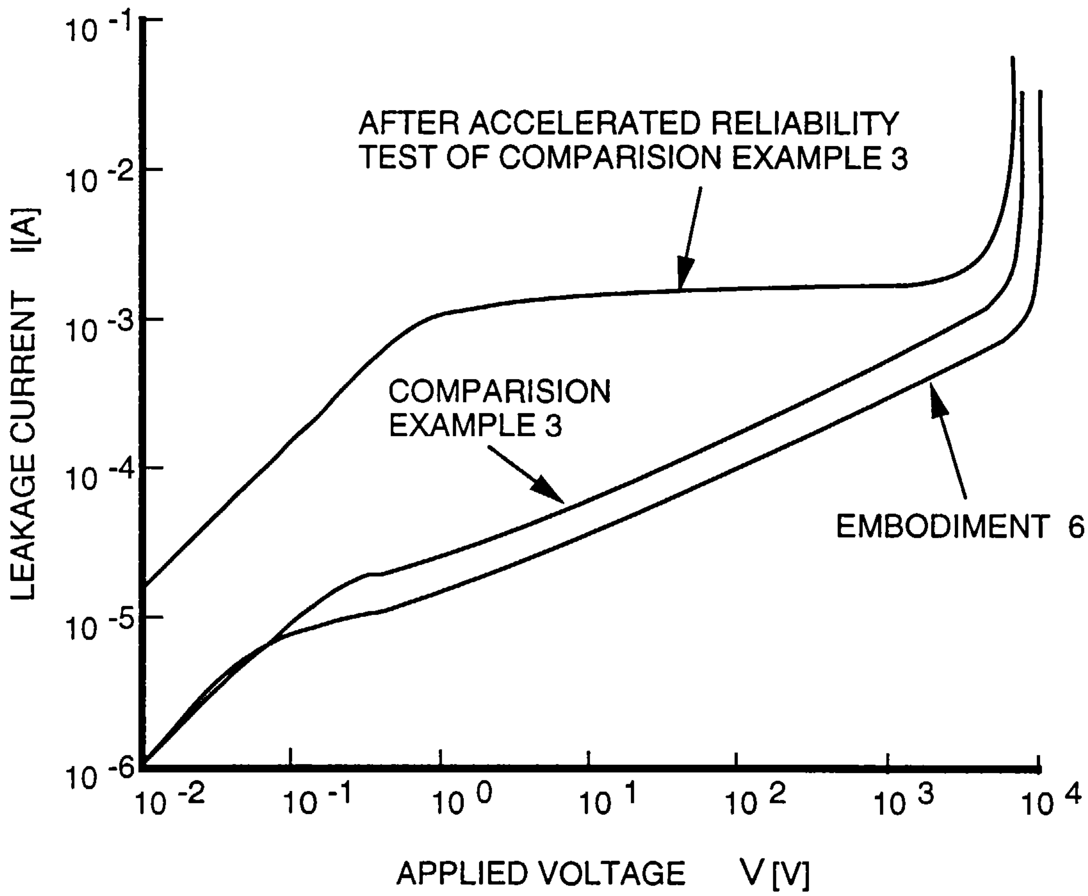
10 -1
10 -2
10 -3
10 -4
10 -5
10 -6
LEAKAGE CURRENT I[A]
AFTER ACCELERATED RELIABILITY
TEST OF COMPARISION EXAMPLE 3
COMPARISION
EXAMPLE 3
EMBODIMENT 6
10 -2
10 -1
10 0
10 1
10 2
10 3
10 4
APPLIED VOLTAGE V [V]

FIG.13

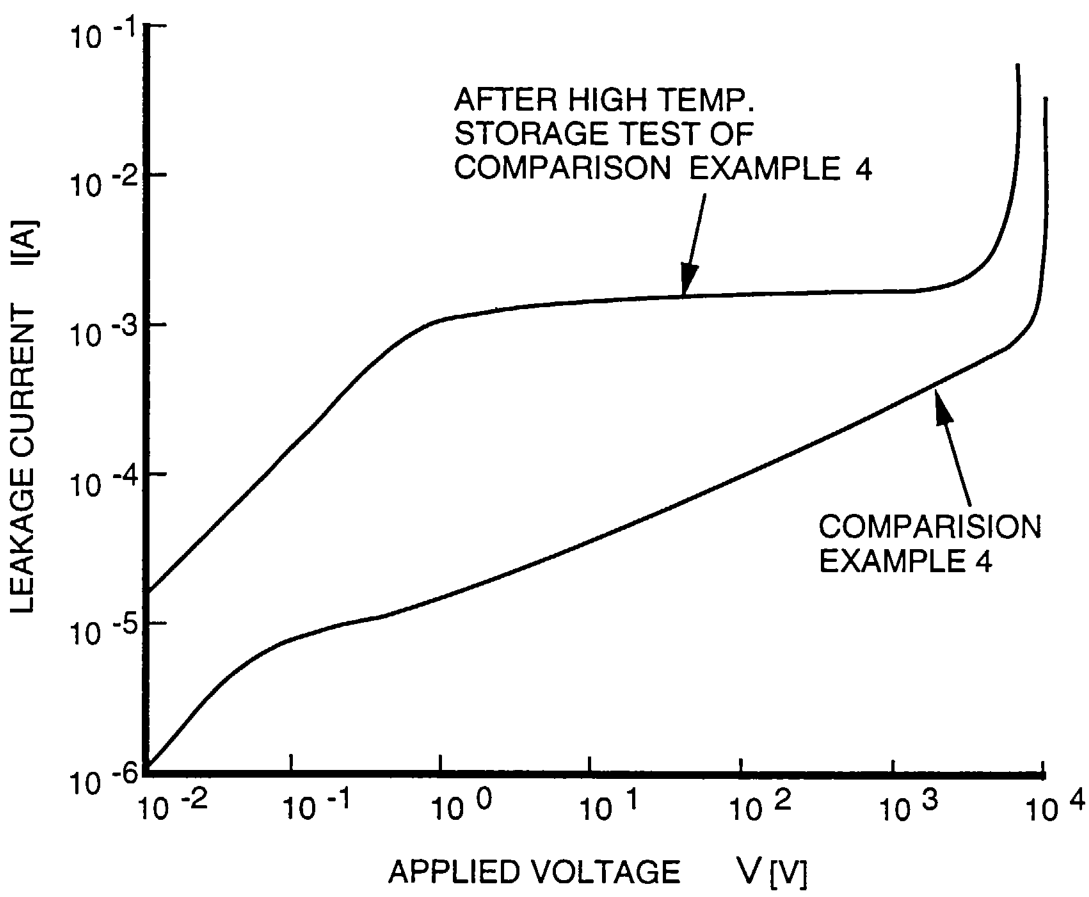
10 -1
10 -2
10 -3
10 -4
10 -5
10 -6
LEAKAGE CURRENT I[A]
AFTER HIGH TEMP.
STORAGE TEST OF
COMPARISON EXAMPLE 4
COMPARISION
EXAMPLE 4
10 -2
10 -1
10 0
10 1
10 2
10 3
10 4
APPLIED VOLTAGE V [V]

FIG.14

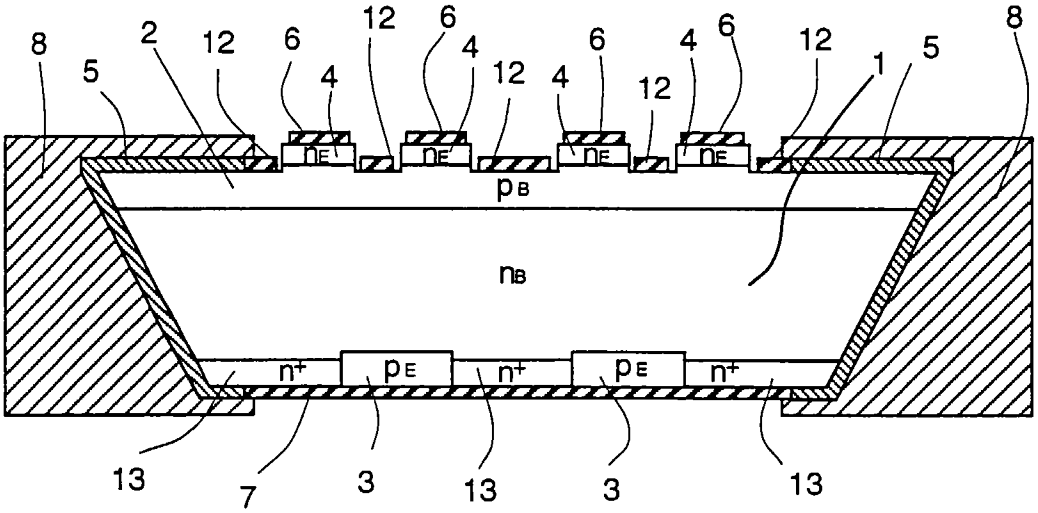
8
2
12
6
12
6
4
12
4
6
12
4
6
12
1
5
8
5
nE
pB
nB
n+
pE
n+
pE
n+
13
7
3
13
3
13

FIG.15

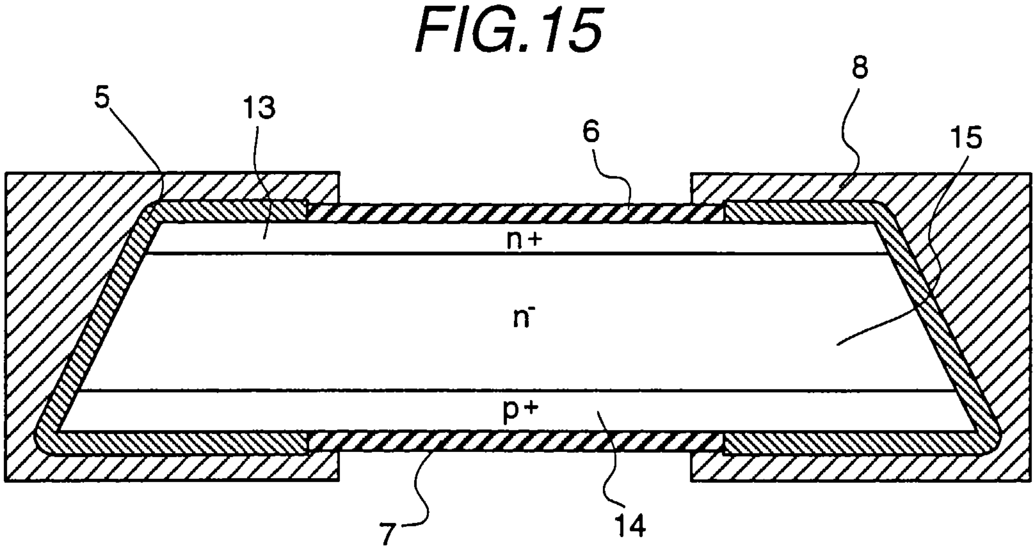
5
13
6
8
15
n+
n-
p+
7
14

FIG.16

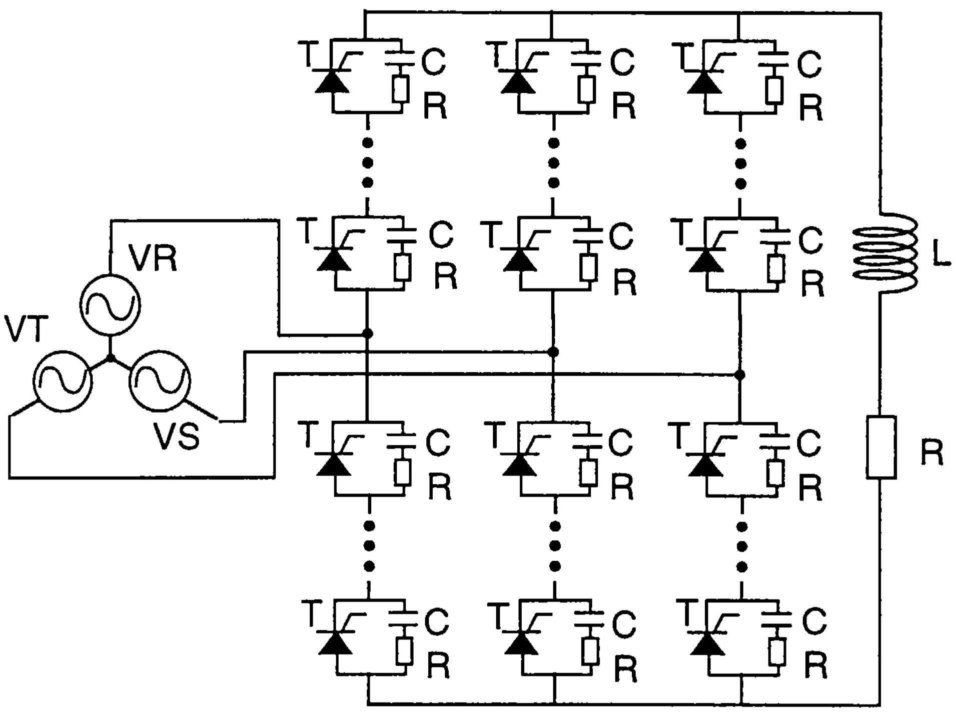

FIG.17

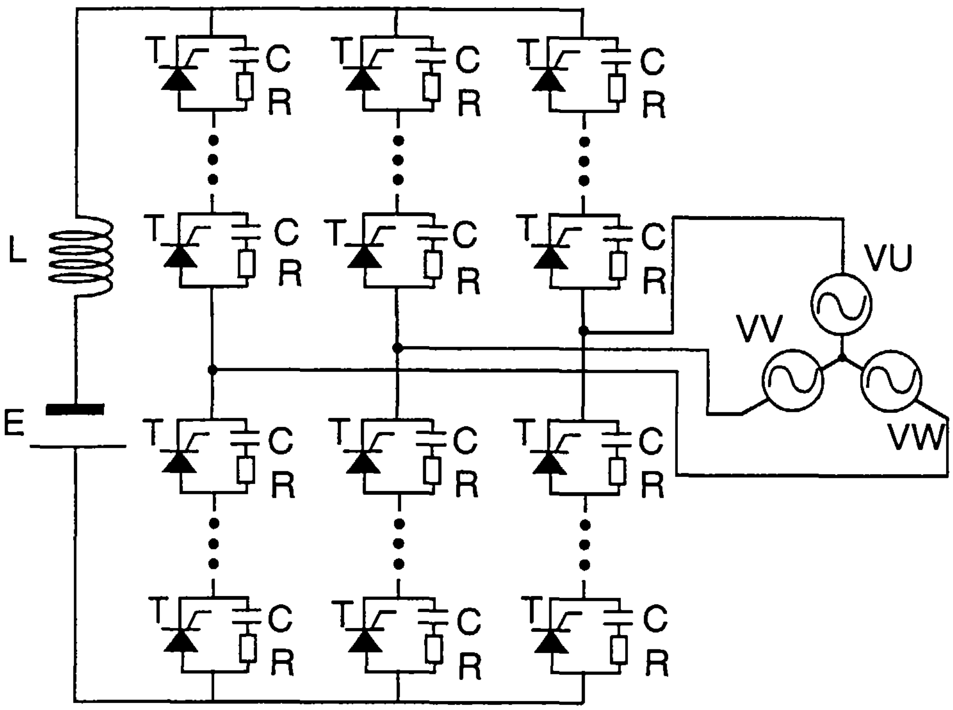

FIG.18

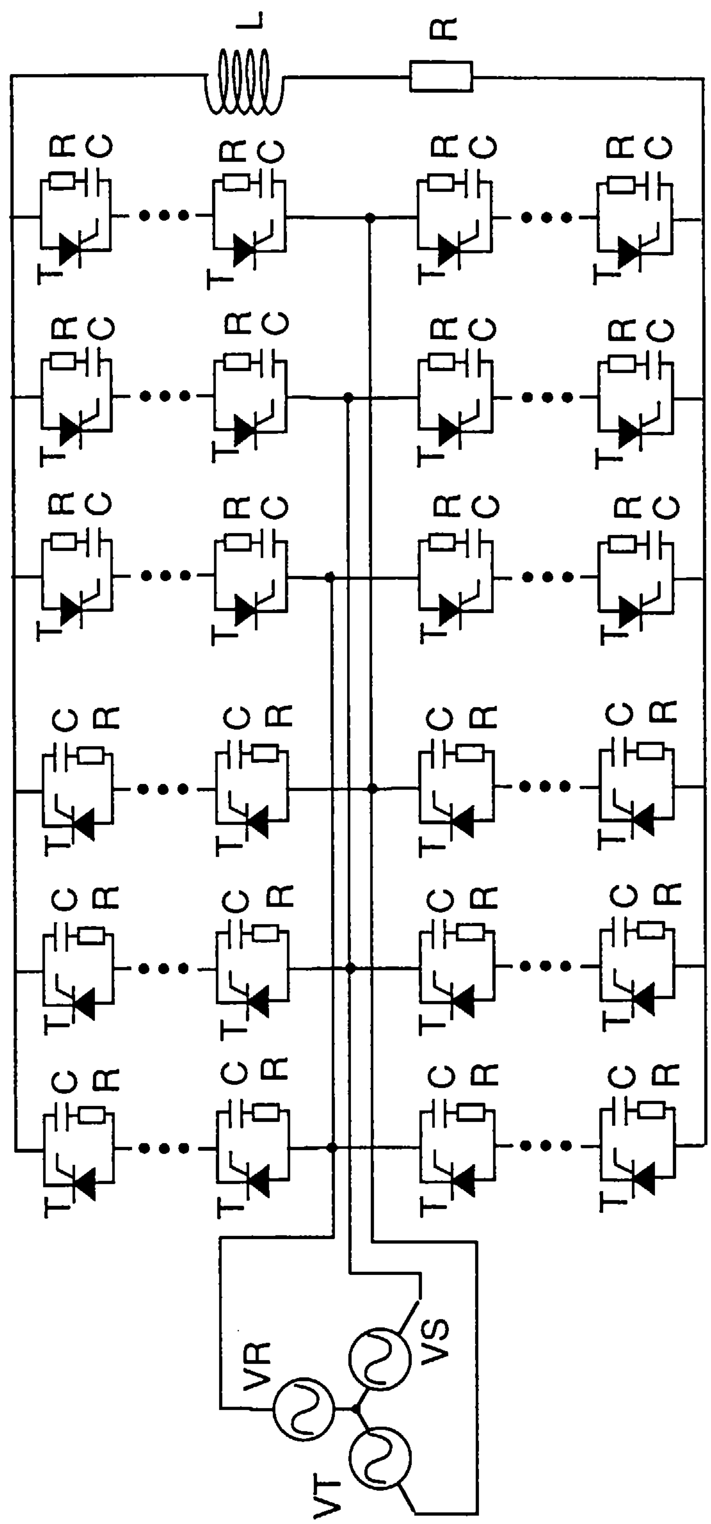

FIG.19

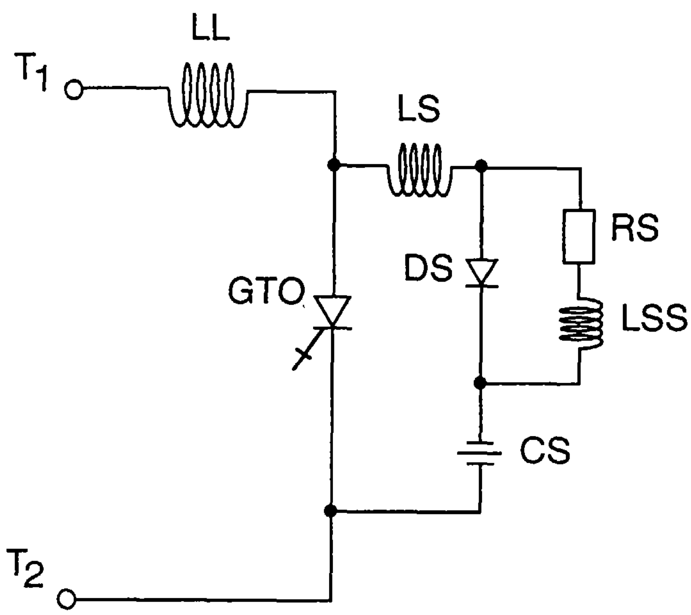


FIG.20

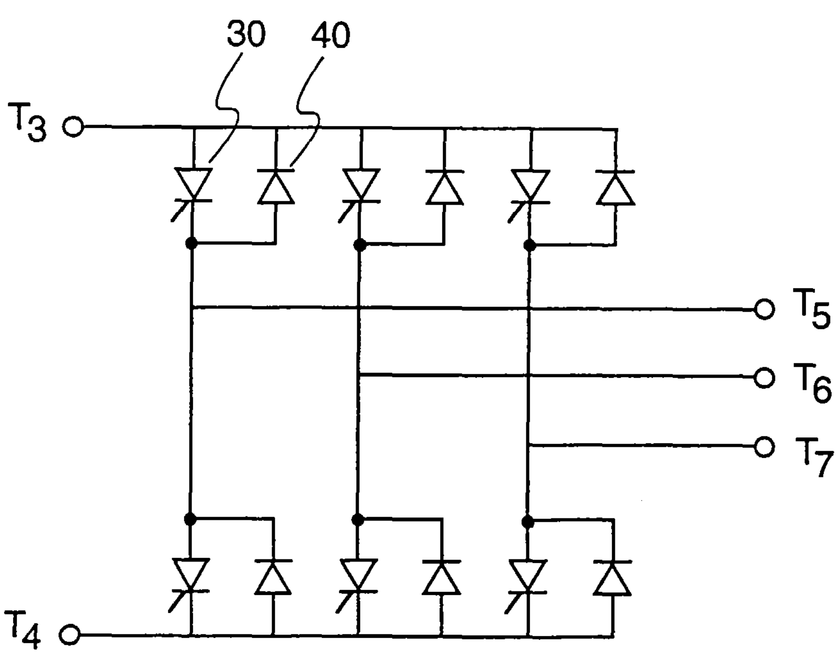

*FIG.21*